# EUROPÄISCHE PATENTSCHRIFT

(11) **EP 1 420 467 B1**
(45) Veröffentlichungstag und Bekanntmachung des Hinweises auf die Patenterteilung: **13.12.2006**
(21) Anmeldenummer: 03103716.1
(22) Anmeldetag: 07.10.2003
(51) Int. Cl.: H01L 41/053, F02M 51/06

(54) **Aktor mit einer Durchführungsöffnung, die bei der Umspritzung gegen eindringenden Kunststoff abgedichtet ist**
Actuator with feed-through opening sealed against intrusion of plastics during overmoulding
Actionneur ayant un trou de passage étanche à la intrusion de matière plastique pendant le surmoulage

(30) Priorität: 28.10.2002 DE 10250202
(43) Veröffentlichungstag der Anmeldung: 19.05.2004
(73) Patentinhaber: SIEMENS AKTIENGESELLSCHAFT, 80333 München (DE)
(72) Erfinder: Albert, Roland, 93047, Regensburg (DE); Heigl, Johann, 93170, Bernhardswald (DE); Mohr, Markus, 91154, Roth (DE); Niesslbeck, Klaus, 92318, Neumarkt (DE)

(56) Entgegenhaltungen:
- WO-A-98/47187
- WO-A-03/069152
- DE-A1- 19 940 347

## Beschreibung

Die Erfindung betrifft einen Aktor mit einer Durchführungsöffnung.

Aus DE 199 40 347 A1 ist ein Aktor mit einer Kopfplatte bekannt, die wenigstens eine Durchführungsöffnung insbesondere für einen elektrischen Kontaktpin aufweist. Eine Kunststoffabdeckung enthält Kontaktpins.

Der Aufbau eines Aktors für Einspritzventile ist aus DE 198 18 068 A1 bekannt. Dort ist ein Piezostack von einer Kopfplatte und einer Bodenplatte stirnseitig begrenzt und von einer zylindrischen Rohrfeder umfasst, die an ihren Stirnöffnungen jeweils mit der Bodenplatte bzw. Kopfplatte verschweisst ist.

Der Erfindung liegt die Aufgabe zu Grunde, bei der Umspritzung eines Bauteil mit Kunststoff die offene Seite einer Durchführungsöffnung zuverlässig gegen eindringenden Kunststoff abzudichten und dabei gleichzeitig eine vorgegebene Bauteillänge einzuhalten. Diese Aufgabe wird mit den Merkmalen des Hauptanspruchs gelöst.

Ein Aktor mit einem piezoelektrischen Element (Stack) enthält Durchführungsöffnungen für jeweils einen elektrischen Kontaktpin, die in der Kopfplatte angeordnet sind, wobei jeweils ein Kontaktzungenträger abgedeckt wird, bevor das Bauteil beziehungsweise die Kopfplatte mit Kunststoff umspritzt wird. Der Kontaktzungenträger trägt somit nicht nur eine oder mehrere Kontaktzungen für die Weiterleitung des elektrischen Stromes, sondern muss auch noch die Abdichtungsfunktion für die Durchführungsöffnung erfüllen.

In der Praxis hat sich jedoch gezeigt, dass sich, um das Montagemaß L einzuhalten, ein kleiner Spalt bilden kann und etwas Kunststoff unter den Kontaktzungenträger kriechen kann. Dieser Kunststoff führt unter Umständen zu einer Beschädigung des Aktors. Eine sehr eng tolerierte Maßhaltigkeit für die einzelnen Bauteillängen muss eingehalten werden. Summieren sich die Längentoleranzen ungünstig, so kann das Montagemaß L nur schwer, durch nachträgliches verbiegen der Kontaktzungen, korrigiert werden. Im schlimmsten Fall ist ein derartiges Bauteil als Fertigungsausschuss zu bewerten, auch wenn seine mechanischen oder elektrischen Funktionen erfüllt sein sollten.

Das erfindungsgemäße Bauteil (Aktor) mit wenigstens einer Durchführungsöffnung in seiner Kopfplatte, in der insbesondere ein Kontaktpin angeordnet ist, mit den kennzeichnenden Merkmalen des Hauptanspruchs hat demgegenüber den Vorteil, dass die Dichtscheibe bei der Umspritzung eine zuverlässige Abdichtung der Durchführungsöffnung gegen eindringenden Kunststoff sicherstellt. Ein Versagen der Abdichtung insbesondere durch eine Spaltbildung oder ein geringes Abheben der Dichtscheibe von der Kopfplatte wird sicher vermieden, da die Oberseite der Kopfplatte im Bereich der Durchführungsöffnung überlappend abgedeckt ist. Des weiteren erscheint als besonders vorteilhaft, dass die Dichtscheibe keinen Einfluss auf eine vorgegebene Bauteillänge hat, so dass die eng tolerierten Maßangaben für die Bauteillänge in jedem Fall exakt eingehalten werden können.

Durch die in den abhängigen Ansprüchen aufgeführten Maßnahmen sind vorteilhafte Weiterbildungen und Verbesserungen des im Hauptanspruch angegebenen Bauteils gegeben. Als besonders vorteilhaft wird angesehen, dass die Dichtscheibe im Bereich der Durchführungsöffnung eine Verdickung aufweist. Durch diese Verdickung wird eine größere Dichtlänge erzielt, so dass sich auch bei hohem Spritzdruck kein Spalt ausbilden kann.

Um eine sichere Fixierung der Dichtscheibe auf der Kopfplatte zu erreichen, kann diese vorzugsweise mit einem entsprechenden Kleber fixiert werden. Eine unerwünschte Spaltbildung wird dadurch noch zuverlässiger vermieden.

Eine günstige alternative Lösung besteht auch darin, die Dichtscheibe vor dem Umspritzen mit einem federnden Element gegen die offene Seite der Durchführungsöffnung 5 zu pressen. Dieser Vorgang lässt sich bisweilen schneller und einfacher in der Serienfertigung durchführen, insbesondere bei einer automatischen Montage der Einzelteile. Auch entfallen mitunter längere Trocknungszeiten für den Kleber in vorteilhafter Weise.

Durch die Abdichtung der Durchführungsöffnung mit der Dichtscheibe ist es nicht mehr notwendig, dass der Kontaktzungenträger direkt auf der Kopfplatte aufliegt. Er kann daher unabhängig von der Dicke der Dichtscheibe beispielsweise über separate Abstandshalter montiert werden und damit die vorgegebene Bauteillänge exakt sicherstellen.

Als besonders vorteilhaft wird auch angesehen, die Dichtscheibe aus einem isolierenden Material wie Kunststoff zu fertigen. Das hat den Vorteil, dass insbesondere bei einem elektrischen Kontaktpin, an dem beispielsweise auch hohe Spannungen auftreten können, gleichzeitig eine entsprechende Isolierung gegen Überschläge entsteht.

Eine alternative vorteilhafte Lösung wird auch in einer Dichtscheibe aus Metall gesehen. Insbesondere bei hohen mechanischen Belastungen erscheinen Metalle wie Kupfer oder dergleichen besonders vorteilhaft.

Die Anwendung der Dichtscheibe insbesondere bei einem Bauteil mit einem piezoelektrischen Element beziehungsweise Aktor hat den Vorteil, dass die Kontaktpins sehr robust ausgeführt wer den können. Dieses ist insbesondere bei einem Injektor für die Kraftstoffeinspritzung in einen Verbrennungsmotor erforderlich, in dem der Aktor eingebaut ist. An dem Bauteil treten hohe Kraftstoffdrücke auf, so dass der Kontaktpin in der Durchführungsöffnung besonders gut abgedichtet sein muss, damit kein Kraftstoff in das Bauteil eindringen kann.

Eine bevorzugte Verwendung des Bauteils ist bei der Benzinoder Dieseleinspritzung gegeben.

Ein Ausführungsbeispiel der Erfindung ist in der Zeichnung dargestellt und wird in der nachfolgenden Beschreibung näher erläutert.
Figur 1 zeigt schematisch die Abdichtung einer Durchführungsöffnung,
Figur 2 zeigt ein Ausführungsbeispiel einer erfindungsgemäßen Abdichtung,
die beiden Figuren 3 zeigen ein bekanntes Bauteil mit einem piezoelektrischen Aktor, bei dem die Durchführungsöffnung nach dem bekannten Stand der Technik abgedichtet wurde,
und die beiden Figuren 4 zeigen die erfindungsgemäße Abdichtung an dem zuvor genannten Bauteil mit dem Aktor.

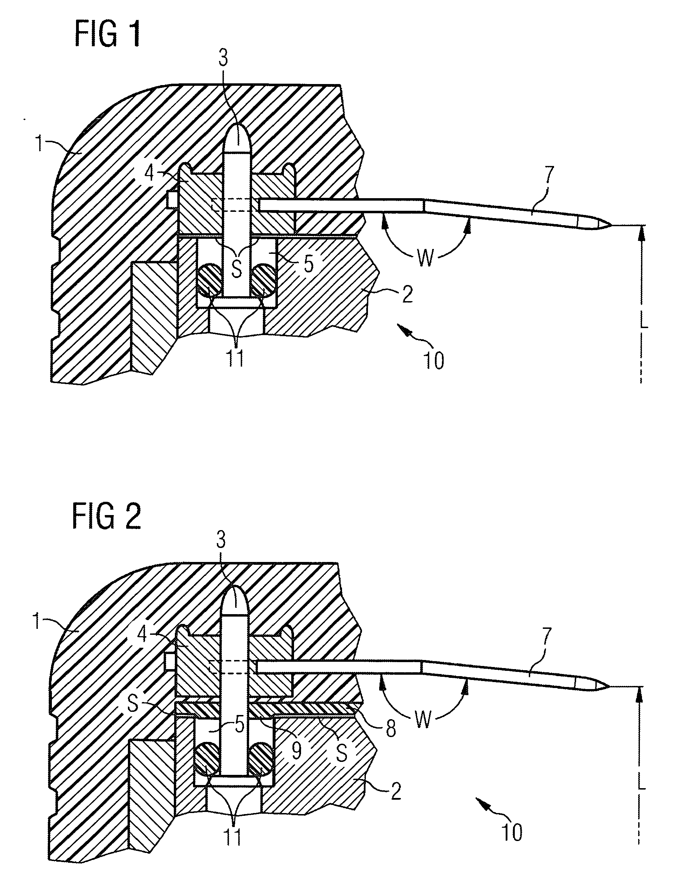

Um die Erfindung besser verständlich zu machen, zeigt Figur 1 zunächst ausschnittsweise ein Bauteil 10 mit einer Durchführungsöffnung 5 in einer Kopfplatte 2, durch die ein Kontaktpin 3 geführt ist. Der Kontaktpin 3 ist innerhalb der Durchführungsöffnung 5 mit einem O-Ring 11 gegen eindringenden Kraftstoff abgedichtet. Auf den Kontaktpin 3 ist ein Kontaktzungenträger 4 derart aufgesetzt, dass er die Durchführungsöffnung 5 abdichten soll, wenn die Kopfplatte 2 beziehungsweise das Bauteil 10 mit Kunststoff 1 (gestrichelte Linie) umspritzt wird. Der Kontaktzungenträger 4 weist entsprechende Kontaktzungen 7 auf, die ein Stück herausragen und mit einem vorgegebenen Winkel W abgewinkelt sind. Als Kopfplatte 2 wird in diesem Fall die obere Fläche des Bauteils 10 bezeichnet.

Das Bauteil 10 weist in diesem Fall ein piezoelektrisches Element, auch Aktor genannt, auf, der über zwei Kontaktpins 3 elektrisch versorgt beziehungsweise gesteuert werden kann. Der Aktor 10 ist in einem Injektor eingesetzt, der beispielsweise die Einspritzmenge von Kraftstoff wie Benzin oder Diesel in einen Verbrennungsmotor steuert.

Bei der Herstellung wird das Bauteils 10 zum Schutz gegen mechanische Beschädigungen in der Regel mit Kunststoff 1 umspritzt. Dabei kann sich an den in Figur 1 mit zwei Pfeilen gekennzeichneten Stellen ein Spalt s bilden, durch den Kunststoff 1 eindringen kann. Durch das Eindringen des Kunststoffs wird dann der Kontaktzungenträger 4 angehoben, so dass sich eine vorgegebene Baulänge L, beispielsweise gemessen zwischen der Spitze der Kontaktzunge 7 und dem Boden des Aktors 10, in unerwünschtem Maße etwas vergrößert. Nach dem Umspritzen ist eine Korrektur der Baulänge L, beispielsweise durch Ändern des Winkels W nur begrenzt möglich, da sich mit dem Winkel W auch die vorstehende Länge der Kontaktzunge 7 in unerwünschtem Maße ändert.

Die Figur 2 stellt das Bauteil 10 aus Figur 1 dar, wobei die Durchführungsöffnung 5 an ihrer offenen Seite mit einer Dichtscheibe 8 überlappend abgedichtet ist. Die Dichtscheibe 8 kann dabei durch Kleben oder Anpressen mit einem federnden Element (in Figur 2 nicht dargestellt) so fixiert werden, dass sich beim Umspritzen kein Spalt s ausbilden kann und somit kein Kunststoff 1 in die Durchführungsöffnung 5 eindringen kann. Die Dichtscheibe 8 kann auch im Bereich der Durchführungsöffnung 5 eine Verdickung 9 aufweisen, die vorzugsweise in die Durchführungsöffnung 5 hineinragt. Dadurch wird eine einfache Justage der Dichtscheibe 8 erzielt und die Dichtfläche vergrößert. Die Dichtscheibe 8 ist beispielsweise aus einem isolierenden Kunststoff oder aus einem Metall wie Kupfer oder dergleichen gefertigt.

Der Kontaktzungenträger 4 wird unabhängig von der Dicke der Dichtscheibe 8 in einem vorgegebenen Abstand auf den Kontaktpin 3 aufgesetzt und hier fixiert. Die vorgegebene Bauteillänge L kann dann unabhängig von der Dicke der Dichtscheibe 8 eingestellt werden. Die Einzeltoleranzen können keinen Einfluss auf die Bauteillänge L ausüben. Auch ist vorteilhaft, dass ein nachträgliches Biegen der Kontaktzungen 7 nicht erforderlich ist.

Ein weiterer Vorteil besteht auch darin, dass die Kraft des Spritzgutes 1, die beim Umspritzen auf die Dichtscheibe 8 wirkt, diese noch stärker auf die Kopfplatte 2 drückt, so dass ein Abheben von der Kopfplatte 2 verhindert wird.

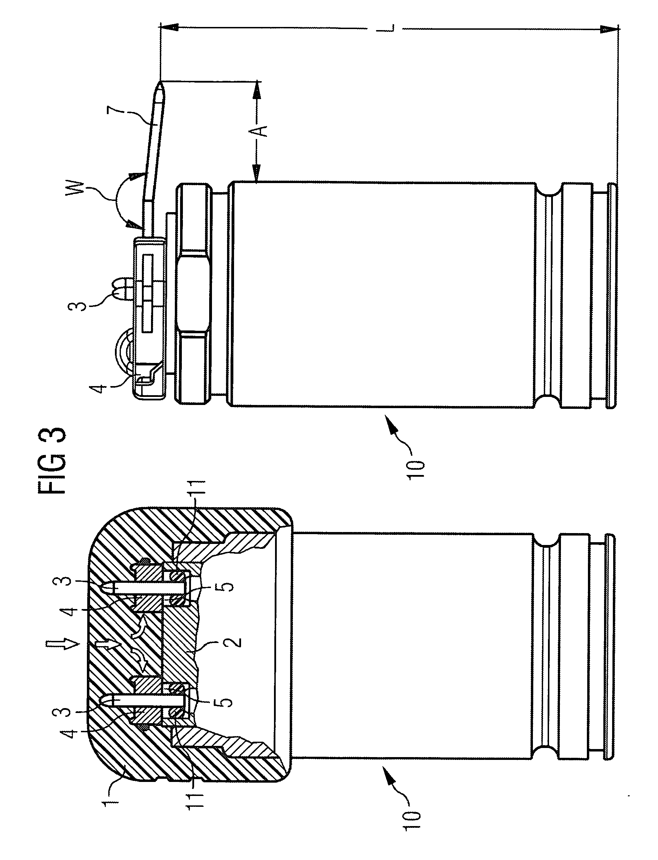

Die beiden Figuren 3 zeigen als Bauteil den zuvor erwähnten Aktor 10, jeweils in Seitenansicht und um ca. 90° gedreht. Diese Bauteile entsprechen dem per se bekannten Aufbau. Bei der linken Figur 3 wurde die Kunststoffumspritzung aufgeschnitten, so dass - ähnlich wie zuvor zu Figur 1 beschrieben wurde - die Kopfplatte 2 mit zwei Durchführungsöffnungen 5 erkennbar ist, in denen die zwei Kontaktpins 3 angeordnet sind. Die dicken Pfeile sollen dabei die Fließrichtung des eingespritzten Kunststoffs 1 und eine damit verbundene mögliche Spaltbildung zwischen der Kopfplatte 2 und dem Kontaktzungenträger 4 kenntlich machen.

Die rechte Figur wurde um ca. 90° gedreht und zeigt insbesondere die Kontaktzungen 7 mit der Abstandslänge A und der Bauteillänge L. Aus Übersichtlichkeitsgründen wurde hier die Kunststoffumspritzung 1 weggelassen.

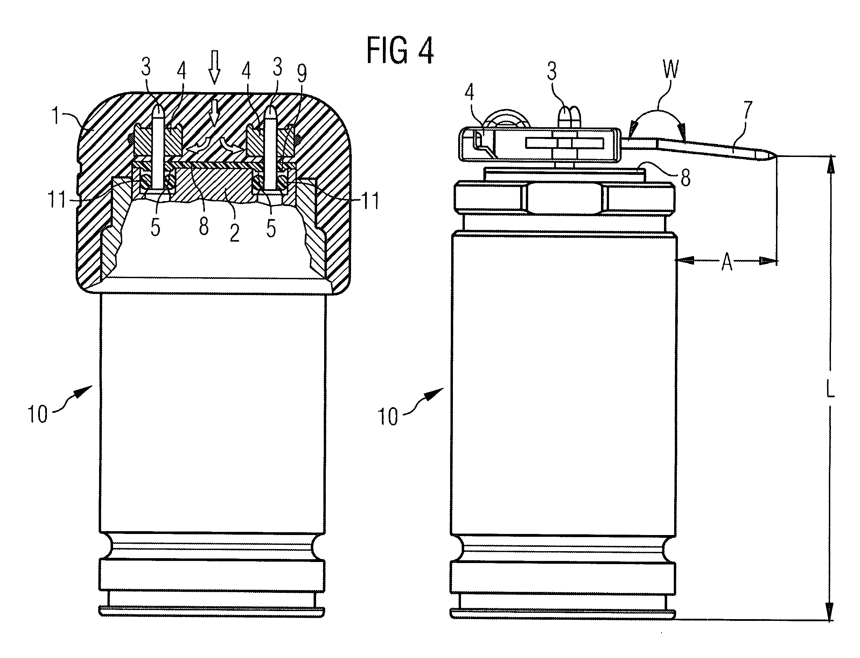

Die beiden Figuren 4 zeigen die entsprechende erfindungsgemäße Ausführungsform des Aktors 10. Wie der linken Figur 4 entnehmbar ist, wurden die beiden Durchführungsöffnungen 5 mit der Dichtscheibe 8 überlappend abgedeckt beziehungsweise abgedichtet. Die Dichtscheibe 8 zeigt in diesem Ausführungsbeispiel wieder eine Verdickung 9, die in die Durchführungsöffnung 5 hineinragt. Der Kontaktzungenträger 4 ist etwas abgesetzt auf die Kontaktpins 3 aufgeschoben und derart angeordnet, dass die vorgegebene Bauteillänge L eingehalten werden kann. Vollständigkeitshalber sei darauf hingewiesen, dass gleiche Bezugsziffern zu allen Figuren die gleiche Bedeutung haben.

Die rechte Figur 4 zeigt den Aktor 10 wieder um ca. 90° gedreht. Hier ist deutlich zu erkennen, wie die Bauteillänge L unabhängig von der Dicke der Dichtscheibe 8 einstellbar ist. Aus Übersichtlichkeitsgründen wurde die Kunststoffumspritzung 1 wieder weggelassen.

Die Erfindung ist nicht auf das Ausführungsbeispiel beschränkt. Erfindungsgemäß ist vorgesehen, die Dichtscheibe 8 bei beliebigen Bauteilen 10 zu verwenden, bei denen eine Durchführungsöffnung 5 abzudichten ist.

## Patentansprüche

1. Aktor (10), insbesondere für ein Kraftstoffeinspritzventil, mit einer Kopfplatte (2), die wenigstens eine Durchführungsöffnung (5) insbesondere für jeweils einen elektrischen Kontaktpin (3) aufweist, auf den ein Kontaktzungenträger (4) mit einer Kontaktzunge (7) aufsetzbar ist und dass die Durchführungsöffnung (5) an ihrer offenen Seite gegen eindringenden Kunststoff (1) bei der Umspritzung geschützt ist, **dadurch gekennzeichnet, dass** auf die offene Seite der Durchführungsöffnung (5) eine Dichtscheibe (8) aufgebracht ist und dass die Dichtscheibe (8) ausgebildet ist, die Oberseite der Kopfplatte (5) wenigstens im Bereich der Durchführungsöffnung (5) überlappend abzudecken und dabei die Durchführungsöffnung (5) dicht zu verschließen.

2. Aktor nach Anspruch 1, **dadurch gekennzeichnet, dass** die Dichtscheibe (8) im Bereich der Durchführungsöffnung (5) mit einer Verdickung (9) ausgebildet ist, die wenigstens teilweise in die Durchführungsöffnung (5) hineinragt.

3. Aktor nach einem der vorhergehenden Ansprüche, **dadurch gekennzeichnet, dass** die Dichtscheibe (8) auf der Oberseite der Kopfplatte (2) fixierbar, vorzugsweise aufklebbar ist.

4. Aktor nach einem der Ansprüche 1 oder 2, **dadurch gekennzeichnet, dass** ein federndes Element vorgesehen ist, das die Dichtscheibe (8) gegen die offene Seite der Durchführungsöffnung (5) drückt.

5. Aktor nach einem der vorhergehenden Ansprüche, **dadurch gekennzeichnet, dass** eine Aktorlänge (L) zwischen der Kontaktzunge (7) des Kontaktzungenträgers (4) und einer Bezugskante des Aktors (10) unabhängig von der Dicke der Dichtscheibe (8) vorgebbar ist.

6. Aktor nach einem der vorhergehenden Ansprüche, **dadurch gekennzeichnet, dass** die Dichtscheibe (8) ein isolierendes Kunststoffmaterial aufweist.

7. Aktor nach einem der vorhergehenden Ansprüche, **dadurch gekennzeichnet, dass** die Dichtscheibe (8) wenigstens teilweise aus Metall ausgebildet ist.

8. Aktor nach einem der vorhergehenden Ansprüche, **dadurch gekennzeichnet, dass** der Aktor (10) ein piezoelektrisches Element aufweist.

9. Aktor nach Anspruch 8 zur Verwendung in einem Injektor für die Kraftstoffeinspritzung in einen Verbrennungsmotor.

10. Aktor nach Anspruch 8 oder 9 zur Verwendung für die Benzin- oder Dieseleinspritzung.

## Claims

1. Actuator (10), in particular for a fuel injection valve, with a top plate (2) having at least one duct opening (5) in particular for, in each case, one electrical contact pin (3) onto which a contact stud carrier (4) with a contact stud (7) can be located and wherein the duct opening (5) is protected on its open side against the ingress of plastic (1) during extrusion coating, **characterised in that** a sealing washer (8) is attached to the open side of the duct opening (5) and that the sealing washer (8) is embodied to cover the top side of the top plate (5) in an overlapping manner at least in the area of the duct opening (5), thereby hermetically sealing the duct opening (5).

2. Actuator according to claim 1, **characterised in that** the sealing washer (8) is embodied in the area of the duct opening (5) with a thickening (9) protruding at least partially into the duct opening (5).

3. Actuator according to one of the preceding claims, **characterised in that** the sealing washer (8) can be fixed into position on the top side of the top plate (2), preferably secured there by means of an adhesive.

4. Actuator according to one of the claims 1 or 2, **characterised in that** a sprung element is provided which presses the sealing washer (8) against the open side of the duct opening (5).

5. Actuator according to one of the preceding claims, **characterised in that** an actuator length (L) can be specified between the contact stud (7) of the contact stud carrier (4) and a reference edge of the actuator (10) independently of the thickness of the sealing washer (8).

6. Actuator according to one of the preceding claims, **characterised in that** the sealing washer (8) has an insulating plastic material.

7. Actuator according to one of the preceding claims, **characterised in that** the sealing washer (8) is embodied at least partially from metal.

8. Actuator according to one of the preceding claims, **characterised in that** the actuator (10) has a piezoelectric element.

9. Actuator according to claim 8 for use in an injector for injecting fuel into an internal combustion engine.

10. Actuator according to claim 8 or 9 for use for injecting petrol or diesel fuel.

## Revendications

1. Actionneur (10), notamment pour une soupape injectrice de carburant, pourvu d'une plaque supérieure (2) qui présente au moins une ouverture de traversée (5) notamment pour respectivement une tige de contact électrique (3) sur laquelle peut être posé un support de linguets de contact (4) avec un linguet de contact (7), de sorte que ladite ouverture de traversée (5) est, lors de l'injection par surmoulage, protégée au niveau de son côté ouvert contre la pénétration de matière plastique (1), **caractérisé en ce qu'**un disque d'étanchéité (8) est appliqué sur le côté ouvert de l'ouverture de traversée (5) et que le disque d'étanchéité (8) est formé pour couvrir par recouvrement la face supérieure de la plaque supérieure (2) au moins dans la zone de l'ouverture de traversée (5) et de fermer ainsi de manière étanche ladite ouverture de traversée (5).

2. Actionneur selon la revendication 1, **caractérisé en ce que** le disque d'étanchéité (8) est formé, dans la zone de l'ouverture de traversée (5), avec une épaisseur plus importante (9) qui s'étend au moins partiellement dans l'ouverture de traversée (5).

3. Actionneur selon l'une des revendications précédentes, **caractérisé en ce que** le disque d'étanchéité (8) peut être fixé, de préférence collé, sur la face supérieure de la plaque supérieure (2).

4. Actionneur selon l'une des revendications 1 ou 2, **caractérisé en ce qu'**il est prévu un élément résilient qui presse le disque d'étanchéité (8) contre le côté ouvert de l'ouverture de traversée (5).

5. Actionneur selon l'une des revendications précédentes, **caractérisé en ce qu'**une longueur d'actionneur (L) peut être définie de manière préalable entre le linguet de contact (7) du support de linguets de contact (4) et une face de référence de l'actionneur (10), et ce indépendamment de l'épaisseur du disque d'étanchéité (8).

6. Actionneur selon l'une des revendications précédentes, **caractérisé en ce que** le disque d'étanchéité (8) présente un matériau isolant en matière plastique.

7. Actionneur selon l'une des revendications précédentes, **caractérisé en ce que** le disque d'étanchéité (8) est formé au moins partiellement en métal.

8. Actionneur selon l'une des revendications précédentes, **caractérisé en ce que** ledit actionneur (10) présente un élément piézoélectrique.

9. Actionneur selon la revendication 8 destiné à être utilisé dans un injecteur réglant l'injection de carburant dans un moteur à combustion interne.

10. Actionneur selon la revendication 8 ou 9 destiné à être utilisé pour l'injection d'essence ou de diesel.
